# EUROPÄISCHE PATENTANMELDUNG

(11) **EP 4 847 462 A1**
(43) Veröffentlichungstag der Anmeldung: **02.12.2026**
(21) Anmeldenummer: 25179614.0
(22) Anmeldetag: 28.05.2025
(51) Int. Cl.: C03C 3/091, C03B 23/203, C03C 3/11

(54) **SUBSTRATSTAPEL MIT ZUMINDEST EINEM ERSTEN UND EINEM ZWEITEN SUBSTRAT SOWIE HERSTELLUNG UND VERWENDUNG EINES SUBSTRATSTAPELS MIT ZUMINDEST EINEM ERSTEN UND EINEM ZWEITEN SUBSTRAT**

(71) Anmelder: SCHOTT AG, 55122 Mainz (DE); SCHOTT Technical Glass Solutions GmbH, 07745 Jena (DE)
(72) Erfinder: LEIRER, Christian, 55122 Mainz (DE); WIESEKE, Hubert, 07745 Jena (DE); SEIBERT, Volker, 55122 Mainz (DE)
(74) Vertreter: Schott Corporate IP

(57) **Zusammenfassung**

Die Erfindung betrifft einen Substratstapel umfassend zumindest ein erstes Substrat und ein zweites Substrat, wobei das Material des ersten Substrats einen thermischen Ausdehnungskoeffizient CTE₁ und das Material des zweiten Substrats einen thermischen Ausdehnungskoeffizienten CTE₂ aufweist, wobei CTE₁ größer als CTE₂ ist oder CTE₁ kleiner als CTE₂ ist und/oder wobei das Material des ersten Substrats einen Elastizitätsmodul E₁ und das Material des zweiten Substrats einen Elastizitätsmodul E₂ aufweist und E₁ größer als E₂ oder E₁ kleiner als E₂ ist, wobei das erste Substrat und das zweite Substrat in deren relativer Lage zueinander dauerhaft oder lösbar festgelegt sind, wobei die dem zweiten Substrat zugewandte Hauptoberfläche des ersten Substrats und die dem ersten Substrat zugewandte Hauptoberfläche des zweiten Substrats bei zumindest einer Fügetemperatur, welche unterhalb der Schmelztemperatur des Materials des ersten Substrats liegt und welche unterhalb der Schmelztemperatur des Materials des zweiten Substrats liegt, jeweils im Wesentlichen zugspannungsfrei ist, sowie dessen Herstellung und Verwendungen von diesem.

## Beschreibung

Die Erfindung betrifft einen Substratstapel mit zumindest einem ersten und einem zweiten Substrat sowie die Herstellung und die Verwendung eines Substratstapels mit zumindest einem ersten und einem zweiten Substrat.

### Stand der Technik

Als Carrier bezeichnete Träger werden bei der Halbleiterchipfertigung sowie bei der Fertigung von Halbleiterbauelementen eingesetzt, um Fertigungsschritte, wie beispielsweise das Dünnschleifen von Halbleiterwafern oder das Packaging von Halbleiterbauelementen, insbesondere in Verfahren wie FOWLP, Fan-out Wafer Level Packaging, oder FOPLP, Fan-out Panel Level Packaging, vorteilhaft zu unterstützen.

Hierbei umfassen Anforderungen an den Carrier mechanische Eigenschaften wie insbesondere ein angepasstes thermisches Ausdehnungsverhalten (CTE) sowie eine geringe Verbiegung (warp) unter verschiedenen äußeren Bedingungen, beispielsweise bei verschiedenen Prozesstemperaturen, welche an die jeweiligen Fertigungsvorgaben angepasst sind. Weiterhin sind Oberflächeneigenschaften, die Schädigungen minimieren können, vorteilhaft. Es werden derzeit Carrier aus Materialien wie Si, Keramik oder Glas eingesetzt. Jedoch sind all diese Carrier auf ein festes initiales Eigenschaftsportfolio beschränkt, welches für spezifische Prozessschritte oder veränderte Fertigungsbedingungen innerhalb eines Prozesses regelmäßig jeweils einen spezifischen Carrier erfordern und damit häufig auch den Wechsel von Carriern bei aufeinanderfolgenden Prozessschritten.

Das Patent US 1210841373 B2 beschreibt Carrier für das Fan-out Packaging mit einem angestrebten effektiven thermischen Ausdehnungskoeffizienten sowie Verfahren zu deren Herstellung. Der als Glaslaminat ausgebildete Carrier umfasst eine aus einer Glaskernzusammensetzung gebildete Glaskernschicht und zwei oder mehr mit der Glaskernschicht verschmolzene Glasmantelschichten. Bei der Herstellung des Carriers mittels eines Overflow-Fusion oder Down-Draw Verfahrens fließt die geschmolzene Glaskernzusammensetzung über zusammengeführte äußere Formflächen eines unteren Überlaufverteilers, wobei gleichzeitig die geschmolzene Glasmantelzusammensetzung um einen oberen Überlaufverteiler herumfließt, um mit der geschmolzenen Glaskernzusammensetzung beidseitig so in Kontakt zu treten, dass diese Glasschichten vollflächig miteinander verschmelzen. Diese oberhalb der Glasschmelztemperaturen gefügten Schichten weisen jedoch nach deren Abkühlung erhebliche intrinsische Spannungen an deren jeweiligen inneren Hauptoberflächen auf, da verschiedene thermische Ausdehnungskoeffizienten für die Glaskernzusammensetzung und die Glasmantelzusammensetzung verwendet werden, um den angestrebten effektiven thermischen Ausdehnungskoeffizienten des Glaslaminats zu erhalten. Als Festigkeitsnachweis für dieses Laminate werden zwar Fallversuche ausgewiesen, intrinsische Spannungen können jedoch, insbesondere bezüglich einer spitzen Punktlast, die mechanische Festigkeit eines solchen Verbunds mindern. Sofern die äußeren Oberflächen dieses Laminats einer weiteren Bearbeitung unterzogen werden sollen, wie bei einem Vorspannen, kann dieses nur beidseitig an den äußeren Oberflächen dieses Laminats erfolgen.

Eine Aufgabe der vorliegenden Erfindung besteht darin, einen Substratstapel bereitzustellen, bei welchem innerhalb des Substratstapels Zugspannungen, insbesondere an Hauptoberflächen von Substraten des Substratstapels vermindert sind.

### Offenbarung der Erfindung

Die Erfindung umfasst einen Substratstapel mit zumindest einem ersten Substrat und einem zweiten Substrat, wobei das Material des ersten Substrats einen thermischen Ausdehnungskoeffizient CTE₁ und das Material des zweiten Substrats einen thermischen Ausdehnungskoeffizienten CTE₂ aufweist, wobei CTE₁ größer als CTE₂ ist oder CTE₁ kleiner als CTE₂ ist.

Durch das Fügen des ersten Substrats mit dem zweiten Substrat kann ein resultierender thermischer Ausdehnungskoeffizient des Substratstapels bereitgestellt werden, dessen Wert zwischen CTE₁ und CTE₂ liegt. Auf diese Weise lassen sich Substratstapel mit thermischen Ausdehnungskoeffizienten bereitstellen, welcher beispielsweise nicht durch ein bekanntes Material mit einem entsprechenden thermischen Ausdehnungskoeffizienten bereitgestellt werden muss.

Hierzu sind das erste Substrat und das zweite Substrat in deren relativer Lage zueinander dauerhaft oder lösbar festgelegt, insbesondere ist hierbei die dem zweiten Substrat zugewandte Hauptoberfläche des ersten Substrats und die dem ersten Substrat zugewandte Hauptoberfläche des zweiten Substrats aneinander gefügt.

Das Fügen kann eine direkt berührende Anlage der entsprechenden Hauptoberfläche des ersten Substrats an der entsprechenden Hauptoberfläche des zweiten Substrats umfassen, wenn das Fügen beispielsweise ein Laserbonden und/oder ein Ansprengen der Substrate aneinander umfasst, kann aber auch das Einfügen einer oder mehrerer Zwischenlagen oder Fügeschichten zwischen dem ersten und dem zweiten Substrat umfassen, wenn beispielsweise das Fügen einen Auftrag eines Klebstoffs, insbesondere in Form einer Klebstoffschicht umfasst.

Generell ist die dem zweiten Substrat zugewandte Hauptoberfläche des ersten Substrats und die dem ersten Substrat zugewandte Hauptoberfläche des zweiten Substrats bei zumindest einer Fügetemperatur, welche unterhalb der Schmelztemperatur des Materials des ersten Substrats liegt und welche unterhalb der Schmelztemperatur des Materials des zweiten Substrats liegt, jeweils im Wesentlichen zugspannungsfrei.

Der Begriff "im Wesentlichen zugspannungsfrei" umfasst Fügeverfahren wie das Laserbonden, welche während des Bondens zu einer starken Erhitzung des Materials des ersten Substrats sowie des Materials des zweiten Substrats im Fokus des bondenden Lasers führen und nach dem Bonden wegen der kurzen Abkühlzeiten dieser zuvor erhitzten Materialbereiche dann zu lokalen Spannungen in den abgekühlten Materialbereichen führen können. Da diese erhitzten und in Folge abgekühlten Materialbereiche jedoch sehr klein im Verhältnis zu den jeweiligen verbleibenden Anteilen der jeweiligen Substrate sind, umfasst der Begriff im Wesentlichen zugspannungsfrei auch derart gefügte Substrate, welche bis auf die in den sehr kleinen Bondbereichen verbleibenden Spannungen ansonsten beim Fügen keinen weiteren Eintrag von Zugspannungen aufweisen.

Das Material des ersten Substrats kann einen Elastizitätsmodul E₁ und das Material des zweiten Substrats einen Elastizitätsmodul E₂ aufweisen und E₁ größer als E₂ oder E₁ kleiner als E₂ sein.

Als Substrat wird im Rahmen der vorliegenden Offenbarung ein flächiger Gegenstand mit sich im Wesentlichen parallel oder parallel zueinander erstreckenden Hauptoberflächen verstanden, wobei die Abmessung der Hauptoberfläche in einer beliebigen Richtung sehr viel größer als der Abstand der Hauptoberflächen zueinander, somit sehr viel größer als dessen Dicke ist.

Generell können die vorliegenden Substrate eine maximale Dicke von 2 mm aufweisen, wobei eine untere Grenze der Dicke bei 30 µm liegen kann. Bevorzugte Werte der Dicke umfassen den Bereich von 100 µm bis 1.5 mm, bevorzugter den Bereich von 0.4 bis 1.1 mm und besonders bevorzugt den Bereich von 0.3 bis 0.5mm.

Dabei können die Hauptoberflächen der Substrate rechteckig, oval und bevorzugt kreisförmig ausgebildet sein. Bevorzugte Durchmesser von Substraten mit kreisförmigen Hauptoberflächen betragen in für die Halbleiterindustrie typischer Weise etwa 150 bis 300 mm, können aber auch größer ausgebildet werden, beispielsweise bis 400 mm oder sogar bis 450 mm betragen.

Bei einer bevorzugten Ausführungsform sind das erste Substrat und das zweite Substrat aneinander liegend, vorzugsweise durch Laserbonden und/oder Ansprengen, dauerhaft festgelegt.

Beim Fügen mittels Laserbonden kann sich eine Vielzahl von Laserbondlinien jeweils senkrecht zu der dem zweiten Substrat zugewandten Hauptoberfläche des ersten Substrats und senkrecht zu der dem ersten Substrat zugewandten Hauptoberfläche des zweiten Substrats jeweils in das erste und in das zweite Substrat erstrecken.

Bevorzugt erstrecken sich dann die Laserbondlinien der Vielzahl von Laserbondlinien in radialem Abstand kreisförmig um den Flächenschwerpunkt der Hauptoberfläche des ersten Substrats und/oder den Flächenschwerpunkt der Hauptoberfläche des zweiten Substrats, vorzugsweise flächengleich beanstandet erstrecken.

Bei einer weiteren Ausführungsform ist zwischen dem ersten Substrat und dem zweiten Substrat eine Fügeschicht angeordnet, welche eine chemisch oder physikalisch abgeschiedene Schicht, insbesondere eine Klebstoffschicht umfasst.

Generell kann das Material des ersten Substrats Glas, Metall, Kunststoff, insbesondere ein Polymer, umfassen und kann auch das Material des zweiten Substrats Glas, Metall und/oder Kunststoff, insbesondere ein Polymer umfassen.

Typische, bei der Halbleiterfertigung auftretende Prozesstemperaturen können die folgenden Werte umfassen:
1. Oxidation: 800 bis 1200 °C - Diese Temperaturen werden verwendet, um Siliziumdioxid-Schichten auf Siliziumwafern zu erzeugen.
2. Diffusion: 800 bis 1200 °C - Bei der Dotierung von Silizium wird das Material bei diesen Temperaturen behandelt, um die gewünschten elektrischen Eigenschaften zu erreichen.
3. CVD (Chemical Vapor Deposition): 300 bis 800 °C - Diese Temperaturen werden verwendet, um dünne Filme von Materialien wie Silizium oder Metallen auf den Wafer aufzubringen.
4. Ätzen: 20 bis 100 °C (chemisches Ätzen) oder 200 bis 400 °C (plasmaunterstütztes Ätzen) - Hierbei handelt es sich um Temperaturen, die bei der Entfernung von Material verwendet werden.
5. Metallisierung: 200 bis 500 °C - Diese Temperaturen sind typisch für die Ablagerung von Metallverbindungen auf den Wafern.
6. Reinigung: 20 bis 80 °C - Bei der Reinigung der Wafer werden oft diese niedrigeren Temperaturen verwendet.

Die vorstehend angegebenen Werte lassen für Reinigung und Ätzen nach sämtliche zuvor angegebenen Materialkombinationen zu.

Für Substratstapel mit Kombinationen von aus Glas bestehenden Substraten ist die Verwendung beim Reinigen, Metallisieren, Ätzen und bei CVD (Chemical Vapor Deposition) möglich. Gleiches gilt für Substratstapel, mit Kombinationen von zumindest einem Substrat, welches Glas umfasst mit zumindest einem Substrat, welches Metall umfasst, wobei Metalle bevorzugt sind, welche bei diesen Temperaturen chemisch resistent, insbesondere nicht oxidierend sind.

Somit kann das Material des ersten Substrats Glas oder Metall umfassen und das Material des zweiten Substrats Glas oder Metall umfassen, wobei die Fügetemperatur vorzugsweise einer für die vorgesehene Verwendung des Substratstapels entsprechenden Prozesstemperatur, insbesondere einer Temperatur aus dem Intervall von 20 bis 300 °C entspricht.

Es kann für die Fügetemperatur, auch ein Intervall von etwa 80 bis 300 °C verwendet werden, welche diese Substratstapel insbesondere bei verschiedenen Fertigungsschritten und den jeweils zugehörigen Prozesstemperaturen ohne deren Austausch verwendbar machen.

Die Übereinstimmung der Füge- mit der späteren Prozesstemperatur kann aufgrund verminderter interner Zugspannungen zu einem während der Prozessierung mechanisch belastbareren Verbund führen, welches mit der technischen Lehre der US 12 084 373 B2 in dieser Weise nicht möglich ist. Als Prozesstemperatur wird hierbei auf die vorstehend angegebenen, in der Halbleiterindustrie typischen Prozesstemperaturen Bezug genommen.

Die sich später dann bei Abweichung von dieser Prozesstemperatur ergebenden Zug- und Druckspannungen können geringer als bei einem bei Raumtemperatur gefügten Substrat sein. Als Raumtemperatur werden Temperaturen in einem Intervall von typischerweise 18 bis 23° C, insbesondere von 22° C angesehen, welche jedoch je nach Fertigungsumgebung auch geringfügig, bis etwa 8° C höher liegen können.

Bei einer besonders bevorzugten Ausführungsform ist an dem ersten Substrat an der dem zweiten Substrat abgewandten Hauptoberfläche zumindest ein erstes weiteres Substrat, welches ein Material mit einem thermischen Ausdehnungskoeffizienten CTE_{W1} und einem Elastizitätsmodul E_{w1} umfasst oder aus diesem besteht, angeordnet.

Das zumindest eine erste weitere Substrat kann der weiteren Einstellung des resultierenden thermischen Ausdehnungskoeffizienten des Substratstapels dienen.

Eine Übereinstimmung des Materials des ersten weiteren Substrats mit dem Material des zweiten Substrats führt zu CTE₂ = CTE_{W1} sowie E₂ = E_{W1} kann bei Temperaturänderungen zu verwölbungsfreien Substratstapeln führen, zumindest soweit das erste weitere Substrat und das zweite Substrat einen weitestgehend symmetrischen Aufbau, insbesondere die gleiche Dicke aufweisen.

In weiterer beispielhafter Ausgestaltung ist an dem zweiten Substrat an der dem ersten Substrat abgewandten Hauptoberfläche zumindest ein zweites weiteres Substrat, welches ein Material mit einem thermischen Ausdehnungskoeffizienten CTE_{W2} und einem Elastizitätsmodul E_{w2} umfasst oder aus diesem besteht, angeordnet.

Auch das zumindest eine zweite weitere Substrat kann der weiteren Einstellung des resultierenden thermischen Ausdehnungskoeffizienten des Substratstapels dienen.

Eine typische Anordnung umfassend einen Substratstapel, wie dieser vorstehend offenbart ist und nachfolgend noch detaillierter beschrieben wird, mit einem an dem Substratstapel angeordneten Gegenstand, wobei der an dem Substratstapel angeordnete Gegenstand insbesondere einen Halbleiter, vorzugsweise einen Halbeiterwafer, einen Halbleiterwafer mit an diesem ausgebildeten Halbleiterbaugruppen sowie vereinzelte Halbleiterbaugruppen umfasst, ist vorteilhaft für in der Halbleiterindustrie auftretende Prozessschritte, da hierbei ein resultierender thermischer Ausdehnungskoeffizient des Substratstapels bereitgestellt werden kann, welcher an verschiedene Prozessschritte angepasst sein kann und keinen Austausch von Trägersubstraten zwischen diesen Prozessschritten benötigt..

Die Herstellung eines Substratstapels, insbesondere eines Substratstapels, wie dieser vorstehend offenbart ist und nachfolgend noch detaillierter beschrieben wird, umfasst das
- Anordnen zumindest eines ersten und eines zweiten Substrats in einer definierten relativen Lage zueinander
- wobei das Material des ersten Substrats einen thermischen Ausdehnungskoeffizient CTE₁ und das Material des zweiten Substrats einen thermischen Ausdehnungskoeffizienten CTE₂ aufweist und CTE₁ größer als CTE₂ ist oder CTE₁ kleiner als CTE₂ ist und/oder
- das Material des ersten Substrats einen Elastizitätsmodul E₁ und das Material des zweiten Substrats einen Elastizitätsmodul E₂ aufweist und E₁ größer als E₂ oder E₁ kleiner als E₂ ist,
- Fügen des ersten Substrats mit dem zweiten Substrat,
- wobei das erste Substrat unmittelbar vor dem Fügen an der dem zweiten Substrat zugewandten Hauptoberfläche und das zweite Substrat unmittelbar vor dem Fügen an der dem ersten Substrat zugewandten Hauptoberfläche jeweils eine Fügetemperatur aufweist, welche unterhalb der Schmelztemperatur des Materials des ersten Substrats und unterhalb der Schmelztemperatur des Materials des zweiten Substrats liegt.

Die vorstehende Formulierung "unmittelbar vor dem Fügen" wurde gewählt, um beim Fügen auch das Laserbonden zu erfassen, denn dieses führt im Bereich des Bondens zu einer lokalen Erwärmung über die jeweilige Schmelztemperatur. Der Begriff "unmittelbar vor dem Fügen" definiert einen Zeitraum bis zum Einsetzen des Fügens, innerhalb welchem im Wesentlichen keine Temperaturänderungen stattfinden.

Allgemein wird als die Fügetemperatur diejenige Temperatur verstanden, bei welcher die zu fügenden Substrate diese Fügetemperatur angenommen haben, insbesondere in deren gesamten Volumen angenommen haben.

Der Begriff der Herstellung wurde gewählt, da patentrechtlich der Ausdruck "Verfahren zur Herstellung" jegliche Verfahren erfassen könnte, welche zu einer entsprechenden Herstellung geeignet sind, der Ausdruck "Herstellung" jedoch nur diejenigen Verfahren erfasst, welche tatsächlich den beanspruchten Gegenstand herstellen.

Bei der Herstellung des Substratstapels kann
- bei dem Anordnen zumindest des ersten und des zweiten Substrats in einer definierten relativen Lage zueinander
- die dem zweiten Substrat zugewandte Hauptoberfläche des ersten Substrats an die dem ersten Substrat zugewandten Hauptoberfläche des zweiten Substrats angelegt werden, vorzugsweise vollflächig angelegt werden, und
- das erste Substrat mit dem zweiten Substrat gefügt werden.

Dann kann beispielsweise
- die dem zweiten Substrat zugewandte Hauptoberfläche des ersten Substrats an die dem ersten Substrat zugewandten Hauptoberfläche des zweiten Substrats angesprengt werden.

Alternativ oder zusätzlich kann auch
- das erste Substrat durch Laserbonden mit dem zweiten Substrat gefügt werden.

Hierbei kann
- während des Laserbondens eine Vielzahl von Laserbondlinien erzeugt werden, die sich jeweils senkrecht zu der dem zweiten Substrat zugewandten Hauptoberfläche des ersten Substrats und senkrecht zu der dem ersten Substrat zugewandten Hauptoberfläche des zweiten Substrats jeweils in das erste und in das zweite Substrat erstrecken,
- wobei sich vorzugsweise die Laserbondlinien der Vielzahl von Laserbondlinien jeweils in radialem Abstand kreisförmig um den Flächenschwerpunkt der Hauptoberfläche des ersten Substrats und/oder den Flächenschwerpunkt der Hauptoberfläche des zweiten Substrats, vorzugswese flächengleich beanstandet erstrecken.

Bei einer weiteren Ausführungsform kann auf die dem zweiten Substrat zugewandte Hauptoberfläche des ersten Substrats und/oder auf die dem ersten Substrat zugewandte Hauptoberfläche des zweiten Substrats zumindest eine Klebstoffschicht aufgebracht und können die Substrate miteinander gefügt werden.

Bei der Herstellung eines Substratstapels kann das Material des ersten Substrats Glas oder Metall umfassen und das Material des zweiten Substrats Glas oder Metall umfassen, wobei die Fügetemperatur vorzugsweise einer für die vorgesehene Verwendung des Substratstapels entsprechenden Prozesstemperatur, insbesondere einer Temperatur aus dem Intervall von 20 bis 300 °C entspricht.

Bei der vorstehend offenbarten und nachfolgend detaillierter beschriebenen Herstellung eines Substratstapels kann an das erste Substrat an der dem zweiten Substrat abgewandten Hauptoberfläche zumindest ein erstes weiteres Substrat, welches ein Material mit einem thermischen Ausdehnungskoeffizienten CTE_{W1} und einem Elastizitätsmodul E_{w1} aufweist, gefügt werden.

Bei der Herstellung des Substratstapels kann an das zweite Substrat an der dem ersten Substrat abgewandten Hauptoberfläche zumindest ein zweites weiteres Substrat, welches ein Material mit einem thermischen Ausdehnungskoeffizienten CTE_{W2} und einem Elastizitätsmodul E_{w2} aufweist, gefügt werden.

Es liegt im Rahmen der vorliegenden Offenbarung, weitere Substrate mit deren Hauptoberflächen an die außenliegenden Hauptoberflächen des vorstehend beschriebenen Substratstapels, insbesondere unter Verwendung des vorstehend offenbarten Fügens anzubringen.

Dabei wird es generell bevorzugt, dass die jeweiligen Hauptoberflächen der aneinander gefügten Substrate eine im Wesentlichen übereinstimmende Form aufweisen, somit gegebenenfalls Substrate mit kreisrunden Hauptoberflächen mit Substraten mit kreisrunden Hauptoberflächen und Substrate mit rechteckförmigen Hauptoberflächen mit Substraten mit rechteckförmigen Hauptoberflächen gefügt werden, wobei vorzugsweise die jeweiligen Flächenschwerpunkte von aneinander gefügten Hauptoberflächen der Substrate einander an im Wesentlichen gleichem Ort, gegebenenfalls durch eine Fügeschicht beabstandet gegenüberliegen.

Die vorliegende Offenbarung umfasst auch einen Substratstapel, welcher wie vorliegend offenbart hergestellt oder herstellbar ist.

Ferner wird auch die Verwendung des vorliegend offenbaren Substratstapels als Träger für einen Gegenstand, insbesondere einen Halbleiter, vorzugsweise einen Halbleiterwafer, einen Halbleiterwafer mit an diesem ausgebildeten Halbleiterbaugruppen sowie vereinzelte Halbleiterbaugruppen umfassend, angegeben.

Besonders vorteilhaft ist auch die Verwendung eines Substratstapels wie dieser vorliegend offenbart wird, zum Tragen eines Gegenstands während mechanischer Bearbeitung, insbesondere während des Polierens, des Schleifens oder des Dünnschleifens des Gegenstands.

Die Erfindung wird nachfolgend anhand der Figuren und ohne Beschränkung hierauf eingehender beschrieben. Gleiche Bezugszeichen bezeichnen dabei gleiche oder ähnliche Elemente.

### Es zeigen

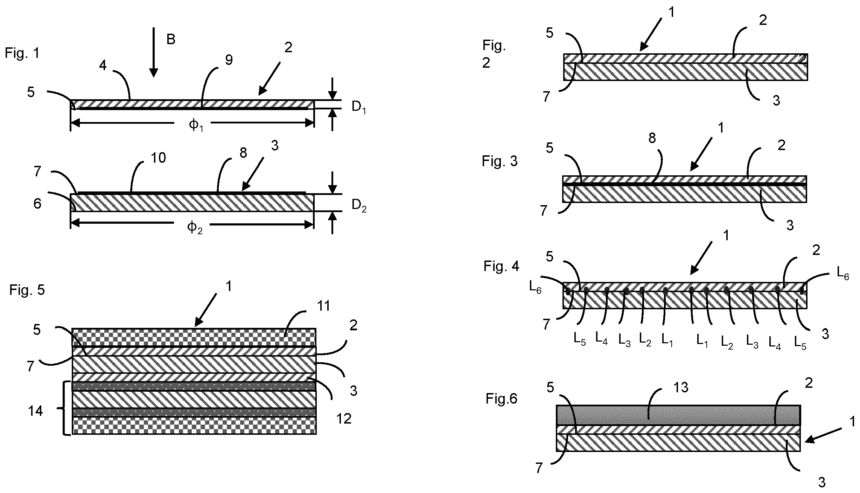

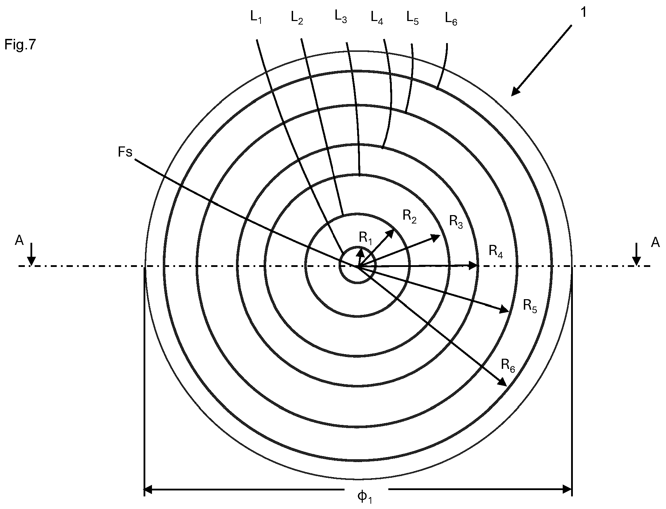

- Figur 1 :: zeigt schematisch ein erstes und ein zweites Substrat vor dem Fügen in einer Querschnittsdarstellung, bei welcher sich der Querschnitt entlang der in Figur 7 dargestellten Ebene AA erstreckt;
- Figur 2:: zeigt schematisch einen Substratstapel mit dem ersten Substrat und dem zweiten Substrat nach dem Fügen mittels Ansprengen in einer Querschnittsdarstellung, bei welcher sich der Querschnitt entlang der in Figur 7 dargestellten Ebene AA erstreckt;
- Figur 3:: zeigt schematisch einen Substratstapel mit dem ersten Substrat und dem zweiten Substrat nach dem Fügen mit Verwendung eines Klebstoffs in einer Querschnittsdarstellung, bei welcher sich der Querschnitt entlang der in Figur 7 dargestellten Ebene AA erstreckt;
- Figur 4:: zeigt schematisch einen Substratstapel mit dem ersten Substrat und dem zweiten Substrat nach dem Fügen mittels Laserbonden in einer Querschnittsdarstellung, bei welcher sich der Querschnitt entlang der in Figur 7 dargestellten Ebene AA erstreckt;
- Figur 5:: zeigt schematisch einen Substratstapel mit dem ersten Substrat und dem zweiten Substrat nach dem Fügen in einer Querschnittsdarstellung, bei welcher sich der Querschnitt entlang der in Figur 7 dargestellten Ebene AA erstreckt, wobei an dem ersten Substrat an der dem zweiten Substrat abgewandten Hauptoberfläche ein erstes weiteres Substrat und an dem zweiten Substrat an der dem ersten Substrat abgewandten Hauptoberfläche zumindest ein zweites weiteres Substrat angeordnet ist;
- Figur 6:: zeigt schematisch einen Substratstapel mit dem ersten Substrat und dem zweiten Substrat nach dem Fügen in einer Querschnittsdarstellung, bei welcher sich der Querschnitt entlang der in Figur 7 dargestellten Ebene AA erstreckt, mit einem an dem Substratstapel angeordneten Gegenstand, wobei der an dem Substratstapel angeordnete Gegenstand einen Halbeiterwafer, mit an diesem ausgebildeten Halbleiterbaugruppen umfasst;
- Figur 7:: zeigt eine Aufsicht auf das erste an ein zweites Substrat mittels Laserbonden gefügte Substrat eines Substratstapels in Richtung des in Figur 1 dargestellten Pfeils B;

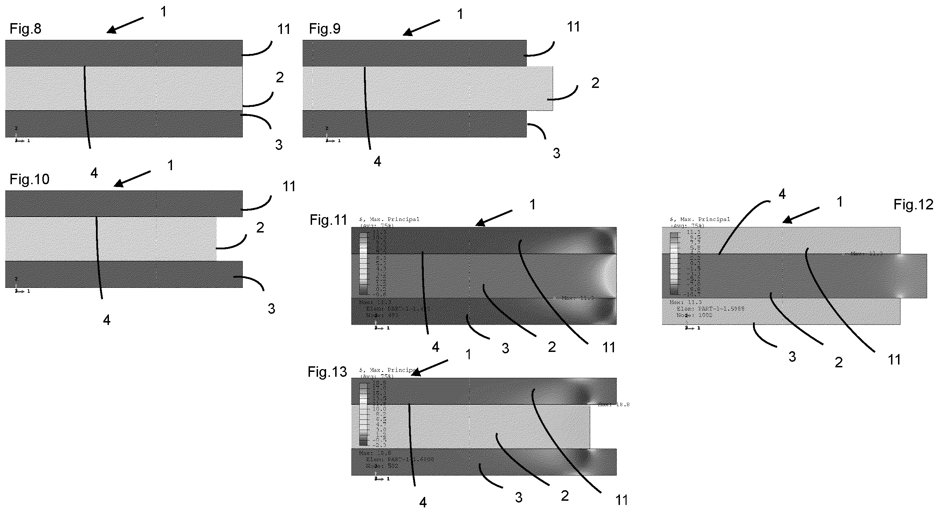

- Figur 8:: zeigt schematisch einen Substratstapel einer ersten quantitativ bezifferten Ausführungsform mit dem ersten Substrat, dem zweiten Substrat und einem ersten weiteren Substrat nach dem Fügen in einer Querschnittsdarstellung, bei welcher sich der Querschnitt entlang der in Figur 7 dargestellten Ebene AA erstreckt;
- Figur 9:: zeigt schematisch einen Substratstapel einer zweiten quantitativ bezifferten Ausführungsform mit dem ersten Substrat, dem zweiten Substrat und einem ersten weiteren Substrat nach dem Fügen in einer Querschnittsdarstellung, bei welcher sich der Querschnitt entlang der in Figur 7 dargestellten Ebene AA erstreckt;
- Figur 10:: zeigt schematisch einen Substratstapel einer dritten quantitativ bezifferten Ausführungsform mit dem ersten Substrat, dem zweiten Substrat und einem ersten weiteren Substrat nach dem Fügen in einer Querschnittsdarstellung, bei welcher sich der Querschnitt entlang der in Figur 7 dargestellten Ebene AA erstreckt;
- Figur 11:: zeigt schematisch den Substratstapel der ersten quantitativ bezifferten Ausführungsform mit dem ersten Substrat, dem zweiten Substrat und einem ersten weiteren Substrat nach dem Fügen in einer Querschnittsdarstellung, bei welcher sich der Querschnitt entlang der in Figur 7 dargestellten Ebene AA erstreckt und in den Substraten bei einem Übergang von Raumtemperatur, RT, zu 200°C auftretende Zugspannungen dargestellt sind;
- Figur 12:: zeigt schematisch den Substratstapel der zweiten quantitativ bezifferten Ausführungsform mit dem ersten Substrat, dem zweiten Substrat und einem ersten weiteren Substrat nach dem Fügen in einer Querschnittsdarstellung, bei welcher sich der Querschnitt entlang der in Figur 7 dargestellten Ebene AA erstreckt und in den Substraten bei einem Übergang von Raumtemperatur, RT, zu 200°C auftretende Zugspannungen dargestellt sind;
- Figur 13:: zeigt schematisch den Substratstapel der dritten quantitativ bezifferten Ausführungsform mit dem ersten Substrat, dem zweiten Substrat und einem ersten weiteren Substrat nach dem Fügen in einer Querschnittsdarstellung, bei welcher sich der Querschnitt entlang der in Figur 7 dargestellten Ebene AA erstreckt und in den Substraten bei einem Übergang von Raumtemperatur, RT, zu 200°C auftretende Zugspannungen dargestellt sind.

Nachfolgend wird auf Figur 1 Bezug genommen, welche schematisch ein erstes Substrat 2 und ein zweites Substrat 3 vor dem Fügen in einer Querschnittsdarstellung zeigt, bei welcher sich der Querschnitt entlang der in Figur 7 dargestellten Ebene AA erstreckt.

Das Material des ersten Substrats 2 weist einen thermischen Ausdehnungskoeffizient CTE₁ und das Material des zweiten Substrats 3 einen thermischen Ausdehnungskoeffizienten CTE₂ auf, wobei CTE₁ größer als CTE₂ ist oder CTE₁ kleiner als CTE₂.

Das Material des ersten Substrats weist einen Elastizitätsmodul E₁ und das Material des zweiten Substrats einen Elastizitätsmodul E₂ auf, wobei E₁ größer als E₂ oder E₁ kleiner als E₂ ist,

Beispiele für das Material des ersten Substrats sowie des zweiten Substrats sind für Gläser der nachfolgenden Tabelle I zu entnehmen.

**Tabelle I**

| Substratmaterial | Elasitizitäts-Modul | Poissonzahl | thermischer Ausdehnungskoeffizient |
|---|---|---|---|
| | E [MPa] | υ [ ] | α [10⁻⁶ K⁻¹] |
| Glas 1 | 63000 | 0.2 | 3.3 |
| Glas 2 | 78600 | 0.24 | 3.77 |
| Glas 3 | 69000 | 0.192 | 4.2 |
| Glas 4 | 66000 | 0.235 | 4.5 |

Im Rahmen der vorliegenden Offenbarung wird als thermischer Ausdehnungskoeffizient CTE jeweils der Längenausdehnungskoeffizient α für das Temperaturintervall von 20 bis 300 °C angeben.

Glas 1 weist die nachfolgend angegebene Zusammensetzung in Gewichtsprozent auf:
80.8 % SiO₂
12.7 % B₂O₃
2.4 % Al₂O₃
3.5 % Na₂O
0.5 % K₂O
0.1 % NaCl

Glas 2 weist die nachfolgend angegebene Zusammensetzung in Gewichtsprozent auf:
61.1 % SiO₂
7.8 % B₂O₃
16.2 % Al₂O₃
2.7 % MgO
8.2 % CaO
3.5 % BaO
0.5% SnO₂

Glas 3 weist die nachfolgend angegebene Zusammensetzung in Gewichtsprozent auf:
78.1 % SiO₂
9.8 % B₂O₃
2.5 % Al₂O₃
2.8 % Na₂O
2.5 % K₂O
1.8 % MgO
2.5 % CaO

Glas 4 weist die nachfolgend angegebene Zusammensetzung in Gewichtsprozent auf:
49.45 % SiO₂
14.15 % B₂O₃
11.4 % Al₂O₃
24.0 % BaO
1.0 % Sb₂O₃/As₂O₃

Bei der Auswahl des Materials des ersten Substrats 2 sowie des zweiten Substrats 3 wird generell für das zweite Substrat 3 ein Material mit einem anderen thermischen Ausdehnungskoeffizienten CTE₂ als dem thermischen Ausdehnungskoeffizienten CTE₁ des ersten Substrats gewählt, wodurch in der Regel für das zweite Substrat 3 auch ein anderer Werte des Elastizitätsmoduls E₂ als der Wert des Elastizitätsmoduls E₁ des ersten Substrats 2 bereitgestellt wird. Gleiches gilt auch für die Poisson- oder Querkontraktionszahl υ, wobei deren Einfluss auf die sich ergebenden Zugspannungen eher gering und bei symmetrischen Substratanordnungen, insbesondere zylindersymmetrischen Anordnungen sogar vollständig vernachlässigbar sein kann.

Die Werte des thermischen Ausdehnungskoeffizienten von Glas können allgemein bei Borosilicatgläsern von 2,4*10⁻⁶ bis 9*10⁻⁶ und bei Kalknatrongläsern etwa bei 8*10⁻⁶ bis 9*10⁻⁶ liegen. LABS-Gläser können beispielsweise Werte von 5,3*10⁻⁶ aufweisen, Die Werte des Elastizitätsmoduls von Glas liegen bei 50 bis 130 GPa.

Das Material des ersten Substrats 2 kann jedoch allgemein nicht nur Glas, sondern auch Metall, Kunststoff, insbesondere ein Polymer umfassen oder hieraus bestehen und auch das Material des zweiten Substrats 3 kann allgemein nicht nur Glas, sondern auch, Metall und/oder Kunststoff, insbesondere ein Polymer umfassen oder hieraus bestehen.

Wenn jedoch das Material des ersten Substrats 2 Glas oder Metall umfasst oder hieraus besteht und das Material des zweiten Substrats 3 Glas oder Metall umfasst oder hieraus besteht, können Fügetemperaturen des nachfolgend noch detaillierter beschriebenen Fügens bei einer für die vorgesehene Verwendung des Substratstapels liegenden entsprechenden Prozesstemperatur verwendet werden, insbesondere einer Temperatur aus dem Intervall von 20 bis 300 °C verwendet werden.

Wie bereits einleitend angegeben können die vorliegenden Substrate generell eine maximale Dicke von 2 mm aufweisen, wobei eine untere Grenze der Dicke bei 30 µm liegen kann. Bevorzugte Werte der Dicke umfassen den Bereich von 100 µm bis 1,5 mm, bevorzugter den Bereich von 0.4 bis 1.1 mm und besonders bevorzugt den Bereich von 0.3 bis 0.5mm. Dies gilt somit insbesondere für die Dicke D₁ des ersten Substrats sowie die Dicke D₂ des zweiten Substrats 3.

Dabei können die Hauptoberflächen der Substrate, beispielsweise die dem zweiten Substrat 3 abgewandte Hauptoberfläche 4 des ersten Substrats 2, die dem zweiten Substrat 3 zugewandte Hauptoberfläche 5 des ersten Substrats 2, rechteckig, oval und bevorzugt kreisförmig ausgebildet sein. Bevorzugte Durchmesser von Substraten mit kreisförmigen Hauptoberflächen betragen bei den vorliegend offenbarten Ausführungsformen in für die Halbleiterindustrie typischer Weise etwa 150 bis 300 mm, können aber auch größer ausgebildet werden, beispielsweise bis 400 mm oder sogar bis 450 mm betragen.

Bei der nachfolgenden detaillierten Beschreibung der vorliegenden Ausführungsformen werden jedoch ohne Beschränkung der Allgemeinheit kreisrunde Substrate offenbart, deren Flächenschwerpunkt in einem Substratstapel jeweils am gleichen Ort in Bezug auf deren jeweilige Hauptoberflächen liegt, dies bedeutet in einem Substratstapel jeweils zwischen den einzelnen Substraten keinen seitlichen Versatz in Richtung der Hauptoberflächen der Substrate zueinander aufweist.

Erfindungsgemäß sind das erste Substrat 2 und das zweite Substrat 3 in deren relativer Lage zueinander dauerhaft oder lösbar festgelegt sind, wie dies nachfolgend noch detaillierter, insbesondere bezüglich verschiedener Fügevorgänge beschrieben wird. Hierbei ist die dem zweiten Substrat 3 zugewandte Hauptoberfläche 5 des ersten Substrats 2 und die dem ersten Substrat 2 zugewandte Hauptoberfläche 7 des zweiten Substrats 3 bei zumindest einer Fügetemperatur, welche unterhalb der Schmelztemperatur des Materials des ersten Substrats 2 liegt und welche unterhalb der Schmelztemperatur des Materials des zweiten Substrats 3 liegt, jeweils im Wesentlichen zugspannungsfrei.

Das entsprechende Fügen wird nachfolgend insbesondere unter Bezugnahme auf die Figuren 2 bis 4 beschrieben.

Zunächst wird auf Figur 2 Bezug genommen, welche schematisch einen Substratstapel mit dem ersten Substrat und dem zweiten Substrat nach dem Fügen mittels Ansprengen in einer Querschnittsdarstellung zeigt, bei welcher sich der Querschnitt entlang der in Figur 7 dargestellten Ebene AA erstreckt.

Vor dem Fügen wurde die dem zweiten Substrat 3 zugewandte Hauptoberfläche 5 des ersten Substrats 2 und die dem ersten Substrat 2 zugewandte Hauptoberfläche 7 des zweiten Substrats 3 poliert, insbesondere derart poliert, dass verbliebene Unebenheiten einen Wert von weniger als 1 µm, bevorzugt von weniger als 0,5µm aufwiesen.

Danach wurden die Substrate, 2, 3, vorzugsweise unter Reinraumbedingungen, aneinander gelegt, wodurch sich die Fügeverbindung im Wesentlichen mittels Adhäsion ergab.

Ein weiterer gefügter Substratstapel ist in Figur 3 zu erkennen. Diese Figur zeigt schematisch einen Substratstapel 1 mit dem ersten Substrat 2 und dem zweiten Substrat 3 nach dem Fügen mit Verwendung eines Klebstoffs in einer Querschnittsdarstellung, bei welcher sich der Querschnitt ebenfalls entlang der in Figur 7 dargestellten Ebene AA erstreckt.

Bei dieser Ausführungsform ist zwischen dem ersten Substrat 2 und dem zweiten Substrat 3 eine Fügeschicht 8 angeordnet, insbesondere eine Klebstoffschicht 8 angeordnet, welche eine zuvor am ersten Substrat 2 angeordnete Klebstoffschicht 9 und/oder eine zuvor am zweiten Substrat 3 angeordnete Klebstoffschicht 10 umfasst.

Figur 4 zeigt schematisch einen Substratstapel 1 mit dem ersten Substrat 2 und dem zweiten Substrat 3 nach dem Fügen mittels Laserbonden in einer Querschnittsdarstellung, bei welcher sich der Querschnitt entlang der in Figur 7 dargestellten Ebene AA erstreckt. Bei dieser Ausführungsform des Substratstapel erstrecken sich eine Vielzahl von Laserbondlinien L₁, L₂, L₃, L₄, L₅, L₆ jeweils senkrecht zu der dem zweiten Substrat 3 zugewandten Hauptoberfläche 5 des ersten Substrats 2 und senkrecht zu der dem ersten Substrat 2 zugewandten Hauptoberfläche 7 des zweiten Substrats 3 jeweils in das erste Substrat 2 und in das zweite Substrat 3.

Wie aus Figur 7 zu erkennen ist, erstrecken sich die Laserbondlinien L₁, L₂, L₃, L₄, L₅, L₆ der Vielzahl von Laserbondlinien jeweils in einem zugehörigen radialen Abstand R₁, R₂, R₃, R₄, R₅, R₆ kreisförmig um den Flächenschwerpunkt Fs der Hauptoberfläche 5 des ersten Substrats 2 und/oder den Flächenschwerpunkt der Hauptoberfläche 7 des zweiten Substrats 3, vorzugsweise flächengleich beanstandet. Eine flächengleiche Beabstandung ergibt sich beispielsweise dann, wenn die von der ersten Laserbondlinie L₁ umschlossene Fläche gleich der Fläche ist, welche sich zwischen der ersten und der zweiten Laserbondlinie erstreckt und die bis jeweils zur nächsten Laserbondlinie hinzugekommene Fläche ebenfalls dieser vorgenannten Fläche entspricht.

Die Abstände zwischen den einzelnen Laserbondlinien sind folglich so gewählt, dass die entsprechenden Flächeninhalte der Kreissegmente gleich groß sind. Dies bedeutet, dass die erste der sechs Laserbondlinien an der Stelle liegt, an der deren innere Fläche eine Sechstel der Gesamtfläche beträgt.

Hieraus ergaben sich die nachfolgenden beispielhaften Werte für Substratstapel mit einem Durchmesser Ø_{substrate} von 300, 2 mm, 400,2 mm und 500,2 mm wie folgt:
Ø_{Substrate} [mm] Radien der Laserbondlinien L₁ bis L₆ [mm]

| | |
|---|---|
| 300 | 61.2, 86.6, 106.1, 122.5, 136.9, 150.0 |
| 400 | 70.7, 100.0, 122.5, 141.4, 158.1, 173.2, 187.1/200.0 |
| 500 | 79.1, 111.8, 136.9, 176.8, 193.6, 209.2, 223.6, 137.2, 250.0 |

Ein diesen Anordnungen entsprechender Substratstapel 1 ist in Figur 8 dargestellt, welche schematisch einen Substratstapel 1 einer ersten quantitativ bezifferten Ausführungsform mit dem ersten Substrat 2, dem zweiten Substrat 3 und einem ersten weiteren Substrat 11 nach dem Fügen in einer Querschnittsdarstellung, bei welcher sich der Querschnitt entlang der in Figur 7 dargestellten Ebene AA erstreckt.

Bei dieser besonders bevorzugten Ausführungsform ist an dem ersten Substrat 2 an der dem zweiten Substrat 3 abgewandten Hauptoberfläche 4 zumindest ein erstes weiteres Substrat 11, welches ein Material mit einem thermischen Ausdehnungskoeffizienten CTE_{W1} und einem Elastizitätsmodul E_{w1} umfasst oder aus diesem besteht, angeordnet.

Das zumindest eine erste weitere Substrat 11 kann der weiteren Einstellung des resultierenden thermischen Ausdehnungskoeffizienten des Substratstapels dienen.

Eine Übereinstimmung des Materials des ersten weiteren Substrats 11 mit dem Material des zweiten Substrats führt zu CTE₂ = CTE_{W1} sowie E₂ = E_{W1} kann zu bei Temperaturänderungen verwölbungsfreien Substratstapeln führen, zumindest soweit das erste weitere Substrat und das zweite Substrat die gleiche Dicke aufweisen, wie dies für die in den Figuren 8 bis 13 dargestellten Ausführungsformen der Fall ist.

Für diese Ausführungsformen ergaben sich die nachfolgend in Tabelle II aufgeführten resultierenden thermischen Ausdehnungskoeffizienten αₘ für den Substratstapel 1.

Bei dieser Tabelle bezeichnen die Angaben "Dicke oben" jeweils die Dicke des weiteren Substrats 11, "Dicke Mitte" die Dicke des ersten Substrats und "Dicke unten" die Dicke des zweiten Substrats.

In der nachfolgenden Tabelle II sind jeweils das erste Substrat als das in der Mitte liegende Substrat mit einer Dicke von 0.5 mm, 0.6 mm und von 0.7 mm angegeben.

**Tabelle II**

| | | | |
|---|---|---|---|
| Dicke oben | 0.3 | 0.4 | 0.5 |
| Dicke Mitte | 0.5 | 0.5 | 0.5 |
| Dicke unten | 0.3 | 0.4 | 0.5 |

| Substrate des Stapels1 | resultierender thermischer Ausdehnungskoeffizient αₘ von oben nach unten verlaufend | | |
|---|---|---|---|
| Glas 2/ Glas 1/ Glas 2 | 0.359E-05 | 0.362E-05 | 0.364E-05 |
| Glas 3/ Glas 1/ Glas 3 | 0.381E-05 | 0.387E-05 | 0.392E-05 |
| Glas 4/ Glas 1/ Glas 4 | 0.398E-05 | 0.406E-05 | 0.412E-05 |
| Glas 3/ Glas 2/ Glas 3 | 0.397E-05 | 0.402E-05 | 0.404E-05 |
| Glas 4/ Glas 2/ Glas 4 | 0.414E-05 | 0.419E-05 | 0.423E-05 |
| Dicke oben | 0.3 | 0.4 | 0.5 |
| Dicke Mitte | 0.6 | 0.6 | 0.6 |
| Dicke unten | 0.3 | 0.4 | 0.5 |

| Substrate des Stapels1 | resultierender thermischer Ausdehnungskoeffizient αₘ von oben nach unten verlaufend | | |
|---|---|---|---|
| Glas 2/ Glas 1/ Glas 2 | 0.357E-05 | 0.360E-05 | 0.362E-05 |
| Glas 3/ Glas 1/ Glas 3 | 0.377E-05 | 0.383E-05 | 0.388E-05 |
| Glas 4/ Glas 1/ Glas 4 | 0.393E-05 | 0.401E-05 | 0.408E-05 |
| Glas 3/ Glas 2/ Glas 3 | 0.397E-05 | 0.400E-05 | 0.402E-05 |
| Glas 4/ Glas 2/ Glas 4 | 0.410E-05 | 0.416E-05 | 0.420E-05 |
| Dicke oben | 0.3 | 0.4 | 0.5 |
| Dicke Mitte | 0.7 | 0.7 | 0.7 |
| Dicke unten | 0.3 | 0.4 | 0.5 |

| Substrate des Stapels1 | resultierender thermischer Ausdehnungskoeffizient αₘ von oben nach unten verlaufend | | |
|---|---|---|---|
| Glas 2/ Glas 1/ Glas 2 | 0.355E-05 | 0.358E-05 | 0.361E-05 |
| Glas 3/ Glas 1/ Glas 3 | 0.373E-05 | 0.380E-05 | 0.385E-05 |
| Glas 4/ Glas 1/ Glas 4 | 0.388E-05 | 0.397E-05 | 0.403E-05 |
| Glas 3/ Glas 2/ Glas 3 | 0.395E-05 | 0.398E-05 | 0.400E-05 |
| Glas 4/ Glas 2/ Glas 4 | 0.408E-05 | 0.413E-05 | 0.417E-05 |

Es ist gut zu erkennen, dass die Höhe des resultierenden thermischen Ausdehnungskoeffizienten αₘ des Substratstapels 1 primär vom thermischen Ausdehnungskoeffizienten α des ersten Substrats 2, CTE₁, und der CTE-Differenz der beiden Gläser, nämlich der Differenz des thermischen Ausdehnungskoeffizienten des ersten Substrats 2, CTE₁, zum thermischen Ausdehnungskoeffizienten des zweiten Substrat 3, und in gleicher Weise der des ersten Substrats zum zweiten Substrat 2, CTE₂, abhängt. Hierdurch lässt sich eine Grobeinstellung für den resultierenden thermischen Ausdehnungskoeffizienten αₘ des Substratstapels 1 vornehmen.

Der Einfluss der Dickenänderung der Substrate 2, 3 und 11 auf den resultierenden thermischen Ausdehnungskoeffizienten αₘ des Substratstapels 1 ist erheblich kleiner. Hierdurch lässt sich eine Feineinstellung für den resultierenden thermischen Ausdehnungskoeffizienten αₘ des Substratstapels 1 vornehmen.

Es wird nochmals auf Figur 8 Bezug genommen, welche schematisch den Substratstapel 1 der ersten quantitativ bezifferten Ausführungsform zeigt, bei welcher in einer bevorzugten Ausgestaltung das erste Substrat 2, das zweite Substrat 3 und das erste weitere Substrat 11 einen Durchmesser von jeweils 300 mm aufweisen. Bei dieser Ausgestaltung besteht das Material des ersten Substrats 2 aus dem Glas 1 und das Material des zweiten Substrats 3 sowie des ersten weiteren Substrats 11 aus dem Glas 3. Das erste Substrat 2 weist eine Dicke von 0.5 mm und das zweite Substrat 3 sowie das erste weitere Substrat eine Dicke von jeweils 0.3 mm auf.

Die Substrate 2, 3 und 11 wurden jeweils, wie auch die in den Figuren 9 und 10 dargestellten Substrate 2, 3 und 11 bei Raumtemperatur gefügt, um den jeweiligen Substratstapel 1 zu ergeben.

Lediglich beispielhaft sind in Figur 11 die Zugspannungswerte dargestellt, welche sich bei einer Erwärmung des in Figur 8 dargestellten Substratstapels von Raumtemperatur auf eine Temperatur von 200 ° C ergeben. In überraschender Weise traten dabei in den jeweils aneinander liegenden Hauptoberflächen der Substrate 2, 3, 11 maximale Zugspannungen auf, welche den Wert von 7 MPa nicht überschritten.

Bei einer Erwärmung des Substratstapels 1 von Raumtemperatur auf 100 °C traten bei dieser Ausgestaltung lediglich entsprechende maximale Zugspannungswerte von 3 MPa und bei einer Erwärmung von Raumtemperatur auf 300 °C von 11 MPa auf.

Bei der in Figur 9 dargestellten zweiten quantitativ bezifferten Ausführungsform weist in einer bevorzugten Ausgestaltung das erste Substrat 2 einen Durchmesser von 300 mm auf, wobei das zweite Substrat 3 und das erste weitere Substrat 11 jeweils einen Durchmesser von 299,4 mm aufweisen. Bei dieser Ausgestaltung besteht das Material des ersten Substrats 2 aus dem Glas 1 und das Material des zweiten Substrats 3 sowie des ersten weiteren Substrats 11 aus dem Glas 3. Das erste Substrat 2 weist eine Dicke von 0,5 mm und das zweite Substrat 3 sowie das erste weitere Substrat eine Dicke von jeweils 0,3 mm auf.

Lediglich beispielhaft sind in Figur 12 die Zugspannungswerte dargestellt, welche sich bei einer Erwärmung des in Figur 9 dargestellten Substratstapels von Raumtemperatur auf eine Temperatur von 200 ° C ergeben. In überraschender Weise traten auch hierbei in den jeweils aneinander liegenden Hauptoberflächen der Substrate 2, 3, 11 maximale Zugspannungen auf, welche den Wert von 7 MPa nicht überschritten.

Bei einer Erwärmung des Substratstapels 1 von Raumtemperatur auf 100 °C traten bei dieser Ausgestaltung ebenfalls lediglich entsprechende maximale Zugspannungswerte von 3 MPa und bei einer Erwärmung von Raumtemperatur auf 300 °C von 11 MPa auf.

Bei der in Figur 10 dargestellten dritten quantitativ bezifferten Ausführungsform weist in einer bevorzugten Ausgestaltung das erste Substrat 2 einen Durchmesser von 299,4 mm auf, wobei das zweite Substrat 3 und das erste weitere Substrat 11 jeweils einen Durchmesser von 300 mm aufweisen. Auch bei dieser Ausgestaltung besteht das Material des ersten Substrats 2 aus dem Glas 1 und das Material des zweiten Substrats 3 sowie des ersten weiteren Substrats 11 aus dem Glas 3. Das erste Substrat 2 weist eine Dicke von 0.5 mm und das zweite Substrat 3 sowie das erste weitere Substrat eine Dicke von jeweils 0.3 mm auf.

Lediglich beispielhaft sind in Figur 13 die Zugspannungswerte dargestellt, welche sich bei einer Erwärmung des in Figur 10 dargestellten Substratstapels von Raumtemperatur auf eine Temperatur von 200 ° C ergeben. In überraschender Weise traten hierbei in den jeweils aneinander liegenden Hauptoberflächen der Substrate 2, 3, 11 maximale Zugspannungen auf, welche den Wert von 12 MPa nicht überschritten.

Bei einer Erwärmung des Substratstapels 1 von Raumtemperatur auf 100 °C traten bei dieser Ausgestaltung ebenfalls lediglich entsprechende maximale Zugspannungswerte von 5 MPa und bei einer Erwärmung von Raumtemperatur auf 300 °C von 19 MPa auf.

Hierbei verhielt sich jedoch der jeweilige Anstieg der Zugspannungen im Wesentlichen linear zu der Differenz der Fügetemperatur und zu der Temperatur, auf welche der Substratstapel erhitzt wurde.

Wird nun statt einer Fügetemperatur von Raumtemperatur eine Fügetemperatur von beispielsweise 100 °C verwendet, welches dem Fachmann beispielsweise in entsprechenden räumlich abgegrenzten Bereichen möglich ist, dann ist die dem zweiten Substrat 3 zugewandte Hauptoberfläche 5 des ersten Substrats 2 und die dem ersten Substrat 2 zugewandte Hauptoberfläche 7 des zweiten Substrats 3 bei zumindest dieser Fügetemperatur von 100 °C, welche unterhalb der Schmelztemperatur des Materials des ersten Substrats 2 liegt und welche unterhalb der Schmelztemperatur des Materials des zweiten Substrats 3 liegt, jeweils im Wesentlichen zugspannungsfrei.

Gleiches gilt folglich auch für Fügetemperaturen von 200 °C und von 300 °C, wodurch Substrate bereitstellbar sind, welche durch Wahl der entsprechenden Fügetemperatur bei deren späteren Verwendung bei Prozesstemperatur verminderte Zugspannungen und eine verbesserte mechanische Festigkeit bereitstellen.

Ergänzend wird auf weitere Ausgestaltungen, wie diese insbesondere den Figuren 5 und 6 beispielhaft zu entnehmen sind, eingegangen.

Bei der in Figur 5 nach dem Fügen dargestellten Ausführungsform des Substratstapels 1 mit dem ersten Substrat 2 und dem zweiten Substrat 3 ist an dem ersten Substrat 2 an der dem zweiten Substrat 2 abgewandten Hauptoberfläche 5 ein erstes weiteres Substrat 11 und an dem zweiten Substrat 3 an der dem ersten Substrat 2 abgewandten Hauptoberfläche zumindest ein zweites weiteres Substrat 12 angeordnet.

Das erste weitere Substrat umfasst ein Material mit einem thermischen Ausdehnungskoeffizienten CTE_{W1} und einem Elastizitätsmodul E_{w1} oder besteht aus diesem, wie dies vorstehend bei der Beschreibung der in den Figuren 5 und 7 dargestellten Ausführungsformen angegeben wurde.

Das zweite weitere Substrat 12 umfasst ein Material mit einem thermischen Ausdehnungskoeffizienten CTE_{W2} und einem Elastizitätsmodul E_{w2} oder besteht aus diesem.

Mit beiden weiteren Substraten 11 und 12 lässt sich der resultierende thermische Ausdehnungskoeffizient des Substratstapels 1 weiter beeinflussen.

Es liegt im Rahmen der vorliegenden Offenbarung, die lediglich beispielhaft dargestellten weiteren Substrate 14 zur Ausbildung des Substratstapels 1 an das erste weitere Substrat 11 und/oder das zweite weitere Substrat 12 zu fügen, insbesondere um hierdurch nochmals weiteren Einfluss auf den resultierenden thermischen Ausdehnungskoeffizienten des Substratstapels 1 auszuüben.

In Figur 6 ist schematisch ein Substratstapel 1 mit dem ersten Substrat 2 und dem zweiten Substrat 3, mit einem an dem Substratstapel 1 angeordneten Gegenstand 13 gezeigt, wobei der an dem Substratstapel angeordnete Gegenstand 13 einen Halbeiterwafer, mit an diesem ausgebildeten Halbleiterbaugruppen umfasst.

Obwohl die vorliegende Erfindung anhand bevorzugter Ausführungsbeispiele beschrieben wurde, ist sie nicht darauf beschränkt, sondern auf vielfältige Weise modifizierbar.

### Bezugszeichenliste

- 1: Substratstapel
- 2: erstes Substrat
- 3: zweites Substrat
- 4: dem zweiten Substrat 3 abgewandte Hauptoberfläche des ersten Substrats 2
- 5: dem zweiten Substrat 3 zugewandte Hauptoberfläche des ersten Substrats 2
- 6: dem ersten Substrat 2 abgewandte Hauptoberfläche des zweiten Substrats 3
- 7: dem ersten Substrat 2 zugewandte Hauptoberfläche des zweiten Substrats 3
- 8: Fügeschicht
- 9: Klebstoffschicht am ersten Substrat 2
- 10: Klebstoffschicht am zweiten Substrat 3
- 11: erstes weiteres Substrat
- 12: zweites weiteres Substrat
- 13: am Substratstapel angeordneter Gegenstand
- 14: nochmals weitere Substrate
- Fs: Flächenschwerpunkt
- L₁: Laserbondlinie
- L₂: Laserbondlinie
- L₃: Laserbondlinie
- L₄: Laserbondlinie
- L₅: Laserbondlinie
- L₆: Laserbondlinie
- R₁: Radius der Laserbondlinie L₁ um den Flächenschwerpunkt Fs
- R₂: Radius der Laserbondlinie L₂ um den Flächenschwerpunkt Fs
- R₃: Radius der Laserbondlinie L₃ um den Flächenschwerpunkt Fs
- R₄: Radius der Laserbondlinie L₄ um den Flächenschwerpunkt Fs
- R₅: Radius der Laserbondlinie L₅ um den Flächenschwerpunkt Fs
- R₆: Radius der Laserbondlinie L₆ um den Flächenschwerpunkt Fs

## Patentansprüche

1. Substratstapel umfassend zumindest ein erstes Substrat (2) und ein zweites Substrat (3),
wobei das Material des ersten Substrats (2) einen thermischen Ausdehnungskoeffizient CTE₁ und das Material des zweiten Substrats (3) einen thermischen Ausdehnungskoeffizienten CTE₂ aufweist, wobei CTE₁ größer als CTE₂ ist oder CTE₁ kleiner als CTE₂ ist
und/oder
wobei das Material des ersten Substrats (2) einen Elastizitätsmodul E₁ und das Material des zweiten Substrats (3) einen Elastizitätsmodul E₂ aufweist und E₁ größer als E₂ oder E₁ kleiner als E₂ ist,
wobei das erste Substrat (2) und das zweite Substrat (3) in deren relativer Lage zueinander dauerhaft oder lösbar festgelegt sind,
wobei die dem zweiten Substrat (3) zugewandte Hauptoberfläche des ersten Substrats (2) und die dem ersten Substrat (2) zugewandte Hauptoberfläche des zweiten Substrats (3) bei zumindest einer Fügetemperatur, welche unterhalb der Schmelztemperatur des Materials des ersten Substrats (2) liegt und welche unterhalb der Schmelztemperatur des Materials des zweiten Substrats (3) liegt, jeweils im Wesentlichen zugspannungsfrei ist.

2. Substratstapel nach Anspruch 1, bei welchem das erste Substrat (2) und das zweite Substrat (3) aneinander liegend, vorzugsweise durch Laserbonden und/oder Ansprengen, dauerhaft festgelegt sind.

3. Substratstapel nach Anspruch 1 oder 2, bei welchem sich eine Vielzahl von Laserbondlinien (L₁, L₂, L₃, L₄, L₅, L₆) jeweils senkrecht zu der dem zweiten Substrat (3) zugewandten Hauptoberfläche des ersten Substrats (2) und senkrecht zu der dem ersten Substrat (2) zugewandten Hauptoberfläche des zweiten Substrats (3) jeweils in das erste Substrat (2) und in das zweite Substrat (3) erstrecken.

4. Substratstapel nach vorstehendem Anspruch, bei welchem sich die Laserbondlinien (L₁, L₂, L₃, L₄, L₅, L₆) der Vielzahl von Laserbondlinien in radialem Abstand kreisförmig um den Flächenschwerpunkt der Hauptoberfläche (5) des ersten Substrats (2) und/oder den Flächenschwerpunkt der Hauptoberfläche (7) des zweiten Substrats (3), vorzugsweise flächengleich beanstandet erstrecken.

5. Substratstapel nach Anspruch 1, bei welchem zwischen dem ersten Substrat (2) und dem zweiten Substrat (3) eine Fügeschicht angeordnet ist, insbesondere eine Klebstoffschicht angeordnet ist.

6. Substratstapel nach einem der vorstehenden Ansprüche, bei welchem das Material des ersten Substrats (2) Glas, Metall, Kunststoff, insbesondere ein Polymer umfasst und bei welchem das Material des zweiten Substrats (3) Glas, Metall und/oder Kunststoff, insbesondere ein Polymer umfasst.

7. Substratstapel nach vorstehendem Anspruch, bei welchem das Material des ersten Substrats (2) Glas oder Metall umfasst und das Material des zweiten Substrats (3) Glas oder Metall umfasst, wobei die Fügetemperatur vorzugsweise einer für die vorgesehene Verwendung des Substratstapels entsprechenden Prozesstemperatur, insbesondere einer Temperatur aus dem Intervall von 20 bis 300 °C entspricht.

8. Substratstapel nach einem der vorstehenden Ansprüche, bei welchem an dem ersten Substrat (2) an der dem zweiten Substrat (3) abgewandten Hauptoberfläche zumindest ein erstes weiteres Substrat (11), welches ein Material mit einem thermischen Ausdehnungskoeffizienten CTE_{W1} und einem Elastizitätsmodul E_{w1} umfasst oder aus diesem besteht, angeordnet ist.

9. Substratstapel nach einem der vorstehenden Ansprüche, bei welchem an dem zweiten Substrat (3) an der dem ersten Substrat (2) abgewandten Hauptoberfläche zumindest ein zweites weiteres Substrat (12), welches ein Material mit einem thermischen Ausdehnungskoeffizienten CTE_{W2} und einem Elastizitätsmodul E_{w2} umfasst oder aus diesem besteht, angeordnet ist.

10. Anordnung umfassend einen Substratstapel nach einem der vorstehenden Ansprüche mit einem an dem Substratstapel (1) angeordneten Gegenstand (13), wobei der an dem Substratstapel (1) angeordnete Gegenstand (13) insbesondere einen Halbleiter, vorzugsweise einen Halbeiterwafer, einen Halbleiterwafer mit an diesem ausgebildeten Halbleiterbaugruppen sowie vereinzelte Halbleiterbaugruppen umfasst.

11. Herstellung eines Substratstapels, insbesondere eines Substratstapels nach einem der vorstehenden Ansprüche umfassend
- Anordnen zumindest eines ersten Substrats (2) und eines zweiten Substrats (3) in einer definierten relativen Lage zueinander
- wobei das Material des ersten Substrats (2) einen thermischen Ausdehnungskoeffizient CTE₁ und das Material des zweiten Substrats (3) einen thermischen Ausdehnungskoeffizienten CTE₂ aufweist und CTE₁ größer als CTE₂ ist oder CTE₁ kleiner als CTE₂ ist und/oder
- das Material des ersten Substrats (2) einen Elastizitätsmodul E₁ und das Material des zweiten Substrats (3) einen Elastizitätsmodul E₂ aufweist und E₁ größer als E₂ oder E₁ kleiner als E₂ ist,
- Fügen des ersten Substrats (2) mit dem zweiten Substrat (3),
- wobei das erste Substrat (2) unmittelbar vor dem Fügen an der dem zweiten Substrat (3) zugewandten Hauptoberfläche und das zweite Substrat (3) unmittelbar vor dem Fügen an der dem ersten Substrat (2) zugewandten Hauptoberfläche jeweils eine Fügetemperatur aufweist, welche unterhalb der Schmelztemperatur des Materials des ersten Substrats (2) und unterhalb der Schmelztemperatur des Materials des zweiten Substrats (3) liegt.

12. Herstellung eines Substratstapels nach vorstehendem Anspruch, bei welchem
- bei dem Anordnen zumindest des ersten Substrats (2) und des zweiten Substrats (3) in einer definierten relativen Lage zueinander
- die dem zweiten Substrat (3) zugewandte Hauptoberfläche (5) des ersten Substrats (2) an die dem ersten Substrat (2) zugewandten Hauptoberfläche (7) des zweiten Substrats (3) angelegt wird, vorzugsweise vollflächig angelegt wird, und
- das erste Substrat (2) mit dem zweiten Substrat (3) gefügt wird.

13. Herstellung eines Substratstapels nach vorstehendem Anspruch, bei welchem
- die dem zweiten Substrat (3) zugewandte Hauptoberfläche (5) des ersten Substrats (2) an die dem ersten Substrat (2) zugewandten Hauptoberfläche (7) des zweiten Substrats (3) angesprengt wird.

14. Herstellung eines Substratstapels nach Anspruch 13, bei welchem
- das erste Substrat (2) durch Laserbonden mit dem zweiten Substrat gefügt wird.

15. Herstellung eines Substratstapels nach vorstehendem Anspruch, bei welchem
- während des Laserbondens eine Vielzahl von Laserbondlinien (L₁, L₂, L₃, L₄, L₅, L₆) erzeugt werden, die sich jeweils senkrecht zu der dem zweiten Substrat (3) zugewandten Hauptoberfläche (5) des ersten Substrats (2) und senkrecht zu der dem ersten Substrat (2) zugewandten Hauptoberfläche (7) des zweiten Substrats (3) jeweils in das erste Substrat (2) und in das zweite Substrat (3) erstrecken,
- wobei sich vorzugsweise die Laserbondlinien (L₁, L₂, L₃, L₄, L₅, L₆) der Vielzahl von Laserbondlinien jeweils in radialem Abstand kreisförmig um den Flächenschwerpunkt der Hauptoberfläche (5) des ersten Substrats (2) und/oder den Flächenschwerpunkt der Hauptoberfläche (7) des zweiten Substrats (3), vorzugswese flächengleich beanstandet erstrecken.

16. Herstellung eines Substratstapels nach Anspruch 12, bei welchem auf die dem zweiten Substrat (3) zugewandte Hauptoberfläche (5) des ersten Substrats (2) und/oder auf die dem ersten Substrat (2) zugewandte Hauptoberfläche (7) des zweiten Substrats (3) eine Klebstoffschicht aufgebracht wird und die Substrate miteinander gefügt werden.

17. Herstellung eines Substratstapels nach vorstehendem Anspruch, bei welchem das Material des ersten Substrats (2) Glas oder Metall umfasst und das Material des zweiten Substrats (3) Glas oder Metall umfasst, wobei die Fügetemperatur vorzugsweise einer für die vorgesehene Verwendung des Substratstapels (1) entsprechenden Prozesstemperatur, insbesondere einer Temperatur aus dem **Intervall** von 20 bis 300 °C entspricht.

18. Herstellung eines Substratstapels nach einem der Ansprüche von 12 bis 18, bei welchem an das erste Substrat (2) an der dem zweiten Substrat abgewandten Hauptoberfläche zumindest ein erstes weiteres Substrat, welches ein Material mit einem thermischen Ausdehnungskoeffizienten CTE_{W1} und einem Elastizitätsmodul E_{w1} aufweist, gefügt wird.

19. Herstellung eines Substratstapels nach einem der Ansprüche von 12 bis 19, bei welchem an das zweite Substrat an der dem ersten Substrat (2) abgewandten Hauptoberfläche zumindest ein zweites weiteres Substrat, welches ein Material mit einem thermischen Ausdehnungskoeffizienten CTE_{W2} und einem Elastizitätsmodul E_{w2} aufweist, gefügt wird.

20. Substratstapel hergestellt oder herstellbar mit einem Verfahren nach einem der Ansprüche von 12 bis 21,

21. Verwendung eines Substratstapels nach einem der Ansprüche von 1 bis 11 sowie nach Anspruch 22 als Träger für einen Gegenstand (13), insbesondere einen Halbleiter, vorzugsweise einen Halbleiterwafer, einen Halbleiterwafer mit an diesem ausgebildeten Halbleiterbaugruppen sowie vereinzelte Halbleiterbaugruppen umfassend.

22. Verwendung eines Substratstapels nach einem der Ansprüche von 1 bis 11 sowie nach Anspruch 22 zum Tragen eines Gegenstands (13) während mechanischer Bearbeitung, insbesondere während des Polierens, des Schleifens oder des Dünnschleifens des Gegenstands (13).
